# EUROPEAN PATENT APPLICATION

(11) **EP 2 233 288 A1**
(43) Date of publication of application: **29.09.2010**
(21) Application number: 09004130.2
(22) Date of filing: 23.03.2009
(51) Int. Cl.: B41C 1/10, C08G 18/08, G03F 7/022, G03F 7/039, G03F 7/105

(54) **Radiation sensitive composition and method for preparing radiation sensitive composition**

(71) Applicant: Founder Fine Chemical Industry Co., Ltd., Taiwan 235 (TW); Wang, Tung-Chi, Taiwan 235 (TW); Yeh, Ching-Yu, Taiwan 235 (TW)
(72) Inventor: Yeh, Ching-Yu, Dongshan Township, Yilan County 269 Taiwan 235 (TW); Yang, Ming-Hwa, Dongshan Township, Yilan County 269 Taiwan 235 (TW); Lin, Min-Shyan, Dongshan Township, Yilan County 269 Taiwan 235 (TW); Chen, Shih-Chieh, Dongshan Township, Yilan County 269 Taiwan 235 (TW)
(74) Representative: Merkle, Gebhard

(57) **Abstract**

The present invention provide a method for preparing radiation sensitive composition includes steps of providing 50-95wt% multi-hydroxyl polymers, then mixing 0.1-40wt% isocyanate derivatives and 0-10wt% catalysts corresponding to isocyanate and the multi-hydroxyl polymers to perform cross-linking reaction, and mixing 0.5-45wt% radiation sensitive compound and 1-15wt% coloring agents with the products of the cross-linking reaction. The materials are easily attained in the market and prepared by chemical reactions easily controlled without using materials such as special polymers, copolymers, and other chemical materials. The composition formula is subject to rapid modifications according to diversified demands of individual industrial applications. In addition, the present invention further provides a method for preparing the radiation sensitive composition.

## Description

### BACKGROUND OF THE INVENTION

### Field of the Invention

The present invention relates to a radiation sensitive composition and the method for preparing the radiation sensitive composition for application in printing plates in lithographic printing. More particularly, it relates to a radiation sensitive composition and the method for preparing the radiation sensitive composition used in pre-sensitized photo sensitive lithographic printing plates (PS plates), computer to plate, CTP plates and CTcP plates, or photo resistor of printing circuit boards.

### Description of Prior Art

The general method of producing lithographic PS printing plates has steps of performing electrolyzation or ground on the surface of aluminum substrate to form a plurality of grains required for printing, coating of radiation sensitive composition, which is photo sensitive or heat sensitive, onto the grains of the aluminum substrate forming a radiation sensitive coated layer, baking the radiation sensitive coated layer, then having radiation sensitive coated layer exposed and developed to transfer the pictures and texts from a film onto the radiation sensitive coated layer to form the printing plate for performing printing of the pictures and texts on documents.

More advanced methods of producing CTP or CTcP plates utilize a laser generator driven by digital computer to emit laser beams of infrared (600-1100nm) or ultraviolet (375-450nm) to etch pictures and texts on to radiation sensitive coated layer, following by performing a step of developing the radiation sensitive coated layer to complete the production of the printing plate.

The above mentioned radiation sensitive coated layer is composed of several materials: photo and heat absorbing dyes (photo sensitive agent or heat sensitive agent), acid generator, bakelites (binder ), copolymer, dissolving agents, and aids. The above mentioned materials are disclosed in the R.O.C. Patent No. 94,124,796 and 91,113,336, or U.S. Pat. No. 6,063,544; 5,372,907; 5,340,699; 5,372,915; 5,466,577; 5,491,046; 5,663,037; and 5,919,601.

As the technology utilized in printing industry becomes sophisticated, common standards and configurations are adopted. The selection of photo and heat absorbing dyes are identical. photo and heat absorbing dyes generally include photo sensitive dyes and heat sensitive dyes. Photo sensitive dyes used mainly are 1, 2-Naphthoquinone-2-diazide-4-sulfonyl chloride on, 2-Naphthoquinone-2-diazide-5-sulfonyl chloride and multi-hydroxyl compounds esterification condensates. Heat sensitive dyes used mainly are cyanine dyes, methylidyne dyes , naphthoquinone dyes, and Squaraine Dyes with absorption wavelength at range of 750-830nm. Dissolving agents used mainly are ethylene glycol ethyl ether acetate, Ethylene glycol monobutyl ether, Propylene glycol monoethyl ether, butanone, and 1-Methoxy-2-propanol.

Bakelites are the main solid content and constituent of a radiation sensitive coated layer, which is a polymer made by condensing aldehyde reaction by formaldehyde and the mixture of at least two or above two of the m-cresol, p-cresol, and o-cresol. This is because bakelites have good compatibility with photo sensitive agents and are base soluble. In addition, bakelites have good compatibility with organic dissolving agents and have sufficient hardness to deal with abrasion caused by friction during printing process. Moreover, bakelites are common and easily to get access to.

However, printers are facing the demands to raise the printing efficiency and quality to be more competitive in the industry by increasing the sensitivity of radiation sensitive coated layers on printing plates, which means to reduce the energy and time required for exposure. In addition, the exposed portion is required to be more easily removed by basic solution, and un-exposed portion is required to be more durable in basic solution during developing process. In other words, printing plates have to have better tolerance towards temperature, concentration and required removal time and at the same time keep desirable resolution, inking ability and abrasion resistance of radiation sensitive coated layers. In addition, the adhesiveness between the radiation sensitive coated layer and aluminum substrate has to be improved.

There are challenges to realize demands mentioned above at the same time according to prior art technology. Given that various polymers or copolymers are developed, and formulas are provided to apply in radiation sensitive coated layers, the abovementioned demands are not met completely. According to prior art, aids such as acid generators, surfactants, wetters, and anti-dissolving polymers are added to the formulas such as formulas in European Patent No. EP0,823,327 EP1,464,487; EP1,655,132; EP1,747,884; and U.S. Pat. No. 6,326,122; 6,410,207; and 6,808,861. The major challenge is that most of the aids of above polymers or copolymers are difficult to obtain. Therefore, the printing industry can not make break through due to that the development of formulas of radiation sensitive coated layers is restricted.

### SUMMARY OF THE INVENTION

Accordingly, an object of the present invention is providing a radiation sensitive composition and the method for preparing the radiation sensitive composition with materials easily accessible in the market and chemical reaction easily controlled to obtain optimized radiation sensitive composition, without using special polymers, copolymers or other chemical materials. The composition formula is subject to rapid modifications according to diversified demands of individual industrial applications.

In order to realize the above objective, the present invention provides a method for preparing radiation sensitive composition including steps of providing 50-95wt% multi-hydroxyl polymers, then mixing 0.1-40wt% isocyanate derivatives and 0-10wt% catalysts corresponding to isocyanate and the multi-hydroxyl polymers to perform cross-linking reaction, and mixing 0.5-45wt% radiation sensitive compound and 1-15wt% coloring agents with the products of the cross-linking reaction.

In addition, the present invention further provides a method to prepare the above mentioned radiation sensitive composition.

### DETAILED DESCRIPTION OF THE INVENTION

In cooperation with attached drawings, the technical contents and detailed description of the present invention are described thereinafter according to a preferable embodiment, being not used to limit its executing scope. Any equivalent variation and modification made according to appended claims is all covered by the claims claimed by the present invention.

The radiation sensitive composition according to the present invention is used on a substrate for forming a radiation sensitive coated layer. In one of the preferred embodiment, the substrate is an aluminum substrate but the scope of the invention is not limited to the embodiment. In the preferred embodiment, the radiation sensitive composition is a kind of positive resist material, which means that the exposed regions dissolved in the corresponding developing solution.

The method for preparing radiation sensitive composition includes steps of providing 50-95wt% multi-hydroxyl polymers, mixing 0.1-40wt% isocyanate derivatives and 0-10wt% catalysts corresponding to the isocyanate and the multi-hydroxyl polymers to perform cross-linking reaction, wherein the cross-linking reaction reacted under temperature 10°C-120°C for 1-48 hours. Such that the measured value of the isocyanate reactive group of the isocyanate derivatives is in the range of 0-0.5wt%. Preferably, the measured value of the isocyanate reactive group of the isocyanate derivatives is 0%. The last step is mixing 0.5-45wt% radiation sensitive compound, 1-15wt% coloring agents and products of above mentioned cross-linking reaction.

The major solid content and constituents of radiation sensitive coated layer is multi-hydroxyl polymers. The major content of the multi-hydroxyl polymers applicable to the present invention are bakelites [Novolac resins exp: (A-a,b,c)]. The bakelites can be aldehyde condensing products of the mixture of at least two or above two of the m-cresols, p-cresols, o-cresols and cresol derivatives with formaldehydes, acetaldehydes, other aliphatic or aromatic aldehydes. The molecular weight of multi-hydroxyl polymers is in the range of 1,000 ~ 100,000. Preferably, the molecular weight is in the range of 6,000 ~ 40,000.

The isocyanate derivatives of the present invention are mainly used as modifier and cross linker. The isocyanate derivatives are compounds or polymers containing 1%-40% isocyanate reactive group. The isocyanate derivatives applicable to use in the present invention can be aliphatic having more than one isocyanate function group, aromatic isocyanate and derivatives of aromatic isocyanate, and isothiocyanate. For example, the isocyanate can be a benzyl isocyanate, butyl isocyanate, cyclohexyl isocyanate, 1-adamantyl isocyanate, 1 or 2-mathyl isocyanate, 2-nitrophenyl isocyanate), 2-Thienyl isocyanate, 2-( trifluoromethyl)phenyl isocyanate [CAS: 182500-26-1], 2-chloro-3-fluorophenyl isocyanate [CAS: 93110-05-5], 2-chlorobenzenesulfonyl isocyanate [CAS:64900-65-8], 2-chlorobenzoyl isocyanate, 2-chlorophenyl isocyanate, dodecyl isocyanate, octadecyl isocyanate, P-toluenesulfonyl isocyanate, tolyl isocyanate, 2-(methylthio)phenyl isothiocyanate) [CAS:51333-75-6], hexamethylene diisocyanate (HDI), methylene di-p-phenyl diisocyanate (MDI), naphthalene diisocyanate, isophorone diisocyanate (IPDI)), 3-isocyanatopropyldimethylchlorosilane, 3-isocyanatopropyltrimethoxysilane), benzylsuccinate on polystyrene, methylisocyanate, 1.5-1.9mmal/g on polystyrene, dicyclohexylmethane-4,4-diisocyanate, 2,4(or 2,6)-Toluene diisocyanate (TDI), tetramethylxylene diisocyanate, triphenylmethane-4,4',4"-triisocyanate, 1,3,5-isocyanatohexamethylene triisocyanate, Lysin triisocyanate, triisocyanate triphenyl thiophosphate) [CAS: 4151-51-3], 0,0,0,-tris-(4-isocyanatophenyl) thiophosphate, polymethylenepolyphenyl polyisocyanate) [CAS: 9016-87-9], polymersic MDI isocyanate ), polyisocyanates ( IPDI-isocyanurate, NCO%=12-17% ), polyisocyanates ( HDI-biuret, NCO%=16.5-23% ), and polyisocyanates ( HDI-isocyanates, NCO%=19-23%).

In addition, catalysts corresponding to isocyanate are used to facilitate the reactions. The catalysts can be tertiary amines or organotin compound. The catalysts frequently used are triethylenediamine and dibutyltin dilaurate.

According to prior art disclosed in the R.O.C. Patent No. 91,113,336 and 94,124,796, melamine derivatives are commonly used as cross linkers to increase the sharpness of pictures and printing quality. However, melamine derivatives have low melting point. In addition, the amino group and acid functional group of the melamine derivatives react with each other to different level. The disadvantages result in unstable printing quality when using melamine derivatives. Furthermore, melamine derivatives may have access cross-linking reactions when mixing with anti-dissolving polymers, organic acid, acid derivatives or polymers and have negative impacts such as failed developing process, low sensitivity and color variation of coloring agents. The present invention utilizes isocyanate to effectively increase the sharpness of pictures and printing quality without the disadvantages occurred when using melamine derivatives.

In contrast with prior art such as R.O.C. Patent No. 91,113,336 and 94,124,796, acid generators or secondary acid generators are required in the technology disclosed in U.S. Pat. No. 5,466,557 and 5,919,601. Nonetheless, adding such acid generators has no significant impact in improving characteristics of radiation sensitive coated layer disclosed in the present invention. In other words, it is not required to add acid generator or secondary acid generator according to the present invention.

Moreover, in contrast with prior art such as U.S. Pat. No. 7,033,725; 6,824,947; 7,147,995; and 7,112,397, polymerization reactions are performed with various functional groups or substituent such as monomers of silane, sulfonic, ether, alkylene oxide, phosphoric, meth-acrylamide, meth-acrylate, pyrrolidone, or halogens, to form polymers or copolymers having different function in order to improve characteristics of formulas. The present invention utilizes isocyanate with different substituent (or function group) to accomplish the same effect attained by using above mentioned polymers or copolymers.

Moreover, in contrast with prior art such as R.O.C. Patent No. 91,113,336; 94,124,796; U.S. Pat. No. 5,466,557; 5,919,601, the applied cross linkers or couplers react upon receiving radiations and the reaction level is unpredictable and subject to changes of various factors. In the present invention, isocyanate and isocyanate derivatives perform cross-linking reactions or quality improving chemical reactions in accordance with radiation sensitive composition reaction process, the reaction control is precise. Thus, it is not required to perform isolation or purification process on the products of cross-linking reactions or quality improving chemical reactions. The products are directly applicable to use in the subsequent operation processes of coating, baking, exposure, and developing.

The radiation sensitive compound applicable to the present invention can be heat sensitive compounds (i.e. infrared absorber) or photo sensitive compounds (i.e. UV absorber). The heat sensitive compounds can be cyanine dyes, squalium dyes, croconium dyes, azuleniun dyes, phthalocyanine dyes, naphthalocyanine dyes, polymethine dyes, naphthoquinone dyes, thiopyrilium dyes, dithiol metal complex dyes, anthraquinone dyes, indoaniline metal complex dyes, and intermolecular CT dyes etc. The photo sensitive compounds can be 1, 2-Naphthoquinone-2-diazide-4(or 5)-sulfonyl chloride and hydroxyl-containing alkane, or monomer of hydroxyl-containing aromatic or ester generated by resin reactions.

The usage of coloring agents is to clearly distinguish pictures after developing the printing plates. The coloring agents applicable to the present invention can be oil-soluble dyes or basic dyes , for examples, any or a mixture of the following dyes such as crystal violet, malachite green, victoria blue, methylene blue, ethyl violet, oil blue 603/613), and rhodamine B.

The present invention is illustrated in details by the following embodiments:

### <Embodiment 1>

Firstly, adding 54g ethyl glycol acetate as dissolving agents, along with 26g bakelites Rezicure5200 [SI group, Inc.USA] in a 200ml beaker. Stir the mixture until reactants are completely dissolved to attain solution A.

In addition, add 1.0 g 2,4(or 2,6)-Toluene diisocyanate, Desmodur T80[Bayer], to 6ml ethyl acetate as dissolving agents, to attain solution B.

Add solution B into solution A and stir the mixture under room temperature for 30 minutes. Add 0.001 g dibutyltin dilaurate to the mixture as catalysts. Heat the mixture to 80-90°C and stir the mixture for 5 hours. Measure the amount of isocyanate reactive group (NCO) and continue when the measured amount is zero to attain solution C.

Add 104g 1-methoxypropanediol as dissolving agents, 0.4g cyanine dyes IR dye 23b[PCAS-France] as heat sensitive compounds, 0.4g victoria blue and 0.4g crystal violet lactone as coloring agents in solution C and stir the mixture until reactants are completed dissolved to attain the heat sensitive radiation sensitive composition of Embodiment 1.

Provide a hydrophilic processed aluminum substrate, coat the above mentioned heat sensitive radiation sensitive composition on the aluminum substrate with coating thickness by 1.8 g/m². Followed by baking process at 100°C for 4 minutes. The coated aluminum substrate then is put under a post-baked process at 50°C for 24 hours to attain a positive heat sensitive CTP printing plate.

The following table is the result comparison of developing the positive heat sensitive CTP printing plates with various developing solutions after exposure in Embodiment 1.

| developing solutions | Kodak Premium | Kodak Plus | Kodak Plus | Agfa Energy |
|---|---|---|---|---|
| developing temperature (°C) | 23.0 | 23.0 | 25.0 | 25.0 |
| developing time (seconds) | 35 | 35 | 30 | 20 |
| Total clarity (%) | 60 | 75 | 65 | 60 |
| All pass range (%) | 60∼90 | 75∼90 | 65∼90 | 60∼90 |
| Energy density (mj/cm²) | 91∼37 | 114∼137 | 99∼137 | 91∼137 |

### <Embodiment 2>

Generally identical to the process occurred to positive heat sensitive CTP printing plates in the Embodiment 1. The difference is that bakelites are replaced with 26g DURITE® PD-140A[Hexion specialty chemicals].

### <Embodiment 3>

Generally identical to process occurred to positive heat sensitive CTP printing plates in the Embodiment 1. The difference is that bakelites are replaced with 20 g Rezicure5200 and 6g DURITE® SD-1508.

### <Embodiment 4>

Firstly, add 104g ethyl glycol acetate as dissolving agents, along with 20g bakelites Rezicure5200, 6g DURITE® SD-1508, 0.4g cyanine dyes IR dye 23b[PCAS-France], 0.4g victoria blue, and 0.4g crystal violet lactone to a 200ml beaker and stir the mixture until reactants are completely dissolved to attain solution A.

In addition, add 1.0g 2,4(or 2,6)-Toluene diisocyanate, Desmodur T80[Bayer], to 6ml ethyl acetate as dissolving agents, to attain solution B.

Add solution B into solution A and stir the mixture under room temperature for 30 minutes. Add 0.001g dibutyltin dilaurate to the mixture as catalysts. Heat the mixture to 45-50°C and stir the mixture for 24 hours. Measure the amount of isocyanate reactive group (NCO) and continue when the measured amount is zero to attain solution C.

Add 54g 1-Methoxypropanediol to solution C and stir the mixture until distribution is even to gain the heat sensitive radiation sensitive composition of Embodiment 4.

Apply the method used in the Embodiment 1 to prepare positive heat sensitive CTP printing plates.

### <Embodiment 5>

Generally identical to the process occurred to positive heat sensitive CTP printing plates in the Embodiment 1. The difference is that the applied amount of DesmodurT80 is 1.5g.

### <Embodiment 6>

Generally identical to the process occurred to positive heat sensitive CTP printing plates in the Embodiment 1. The difference is that 1.5g 2-Nathyl isocyanate is replaced by DesmodurT80.

### <Embodiment 7>

Generally identical to the process occurred to positive heat sensitive CTP printing plates in the Embodiment 1. The difference is that 0.66g Triphenylmethane-4,4',4"-triisocyanate is replaced by DesmodurT80.

### <Embodiment 8>

Generally identical to the process occurred to positive heat sensitive CTP printing plates in the Embodiment 1. The difference is that 0.4g 2-(4-Methoxyphenyl)-4,6-bis(trichloromethyl)-1,3,5-triazine is replaced by crystal violet lactone.

### <Embodiment 9>

Generally identical to the process occurred to positive heat sensitive CTP printing plates in the Embodiment 1. The difference is that the coating thickness of the CTP printing plates is 2.02 g/m².

### <Embodiment 10>

Generally identical to the process occurred to positive heat sensitive CTP printing plates in the Embodiment 1. The difference is that the coating thickness of the CTP printing plates is 1.6 g/m².

The following table is the result comparison of developing tests on positive heat sensitive CTP printing plates attained in above mentioned Embodiment 1 to Embodiment 10. The positive heat sensitive CTP printing plates are exposed by Creo-Trendsetter laser generator. The developing solutions used in the developing tests are Kodak premium, developing solution at 24°C with developing time by 35 seconds. The results are as followed.

| No. / Energy Value (mJ/cm²) | 146 | 155 | 165 | 176 | 188 | 203 | 220 |
|---|---|---|---|---|---|---|---|
| Embodiment 1 | 51.4 | 51.3 | 50.9 | 50.5 | 50.3 | 49.9 | 49.8 |
| Embodiment 2 | 50.7 | 50.7 | 50.6 | 50.2 | 49.7 | 49.6 | 49.2 |
| Embodiment 3 | 50.7 | 50.4 | 50.4 | 50.3 | 49.9 | 49.6 | 49.2 |
| Embodiment 4 | 50.7 | 50.8 | 50.8 | 50.6 | 50.2 | 50.1 | 49.8 |
| Embodiment 5 | 50.8 | 50.7 | 50.6 | 50.6 | 50.2 | 49.9 | 49.6 |
| Embodiment 6 | 49.3 | 49.0 | 48.4 | 47.9 | 47.1 | 46.7 | 46.4 |
| Embodiment 7 | 52.9 | 52.4 | 51.3 | 51.2 | 50.6 | 50.3 | 50.4 |
| Embodiment 8 | 51.9 | 51.3 | 51.3 | 50.9 | 50.8 | 50.6 | 49.6 |
| Embodiment 9 | 52.8 | 52.2 | 52.0 | 51.6 | 51.1 | 50.7 | 50.5 |
| Embodiment 10 | 50.1 | 50.0 | 50.0 | 49.9 | 49.6 | 49.5 | 49.1 |

Moreover, the reduction differences in Embodiment 1 to Embodiment 10 are measured with X-rite 528 spectrophotometer. The clear points of Embodiment 1 to Embodiment 10 are measured with steps of first measuring the area with no color changes upon adding alcohol drops on a plate, then performing 50% dot image test with iCPlate2 [X-rite] measurement apparatus. The results are as followed.

| No. | Reduction difference (%) | Clean point | Energy minimum with no laser marking |
|---|---|---|---|
| Embodiment 1 | 0.10 | 146mJ/cm² | - |
| Embodiment 2 | 0.12 | 146mJ/cm² | - |
| Embodiment 3 | 0.13 | 146mJ/c² | - |
| Embodiment 4 | 0.11 | 146mJ/cm² | |
| Embodiment 5 | 0.09 | 146mJ/cm² | - |
| Embodiment 6 | 0.15 | 146mJ/cm² | - |
| Embodiment 7 | 0.08 | 176mJ/cm² | 188mJ/cm² |
| Embodiment 8 | 0.10 | 155mJ/cm² | 165mJ/cm² |
| Embodiment 9 | 0.08 | 188mJ/cm² | 203mJ/cm² |
| Embodiment 10 | 0.12 | 146mJ/cm² | |

According to the above data, it is apparent that the positive heat sensitive CTP printing plates of the present invention have high sensitivity and sufficient alkali resistance. In addition, the radiation sensitive composition used for preparing positive heat sensitive CTP printing plates according to the present invention can be prepared by materials easily access in the market.

The present invention further provides CTcP printing plates applicable to UV-CTP technology in the following. The UV-CTP technology is used for performing direct digital etching with UV lights or UV laser on prior art PS plates (also known as CTcP technology).

### <Embodiment 11>

Firstly, add 84g ethyl glycol acetate as dissolving agents along with 26g bakelites DURITE® PD-140A in a 200ml beaker. Stir the mixture until reactants are completely dissolved to attain solution A.

In addition, add 1.5g 2,4(or 2,6)-Toluene diisocyanate, Desmodur T80[Bayer], to 9ml ethyl acetate as dissolving agents, to attain solution B.

Add solution B into solution A and stir the mixture under room temperature for 30 minutes. Add 0.001g dibutyltin dilaurate to the mixture as catalysts. Heat the mixture to 80-90°C and stir the mixture for 5 hours. Measure the amount of isocyanate reactive group (NCO) and continue when the measured amount is zero to attain solution C.

Add 104g ethylene glycol monoethyl ether as dissolving agents, 4.2g [1.2-Naphthoquinone-(2)-Diazido-5-Sulfonyl chloride with pyrogalloacetone], 1.4g [1.2-Naphthoquinone-(2)-Diazido-5-Sulfonyl chloride with 2,3,4,Tetra-Hydroxy -Benzophenone], 1.5g victoria blue , 0.15g Triazine B to solution C. Stir the mixture until reactants are completely dissolved to attain UV photo sensitive radiation sensitive composition of Embodiment 11.

Provide a hydrophilic processed aluminum substrate, and coat the above mentioned UV radiation sensitive radiation sensitive composition on the aluminum substrate with coating thickness by 1.8 g/m². Followed by baking process at 100°C for 4 minutes. The coated aluminum substrate then is put under a post-baked process at room temperature for 24 hours to attain a positive photo sensitive CTcP printing plate.

Moreover, perform a test on the positive photo sensitive CTcP printing plates prepared in Embodiment 11 with Basysprint UV-Setter laser generator. The tested coating thickness is 1.9 g/m², the developing solution is three folds diluted compare to developing solution used with prior art PS, the developing solution temperature is 28°C, the developing time is 30 seconds. The resulting clean point is 90mj/cm² , the reduction difference < 0.12. The resulting performance is higher than other CTcP plates available in the markets.

## Claims

1. A method for preparing radiation sensitive composition comprising steps:
(A) providing 50-95wt% multi-hydroxyl polymers ;
(B) mixing 0.1-40wt% isocyanate derivatives, 0-10wt% catalysts corresponding to isocyanate derivatives and said multi-hydroxyl polymers to perform cross-linking reaction;
(C) mixing 0.5-45wt% radiation sensitive compound, 1-15wt% coloring agents, and products of said cross-linking reaction.

2. The method for preparing radiation sensitive composition of claim 1, wherein said multi-hydroxyl polymers are bakelites having molecular weights in the range of 1,000 ∼ 100,000.

3. The method for preparing radiation sensitive composition of claim 2, wherein said bakelites have molecular weights in the range of 6,000 ∼ 40,000.

4. The method for preparing radiation sensitive composition of claim 1, wherein said isocyanate derivatives are aliphatic isocyanates, aromatic isocyanates and derivatives of said aliphatic isocyanates, aromatic isocyanates, or sulfonyl isocyanate derivatives having more than at least one isocyanate function group.

5. The method for preparing radiation sensitive composition of claim 1, wherein said catalysts are tertiary amines or organotin compounds.

6. The method for preparing radiation sensitive composition of claim 1, wherein said radiation sensitive compound are heat sensitive compounds or photo sensitive compounds.

7. The method for preparing radiation sensitive composition of claim 1, wherein said coloring agent are oil-soluble dyes or basic dyes.

8. The method for preparing radiation sensitive composition of claim 1, wherein said cross-linking reaction react under temperature 10°C-120°C for 1-48 hours.

9. The method for preparing radiation sensitive composition of claim 8, wherein measured values of isocyanate reactive groups of said isocyanate derivatives are less than 0.5wt% after said cross-linking reaction.

10. The method for preparing radiation sensitive composition of claim 9, wherein measured values of said isocyanate reactive group of said isocyanate derivatives is 0% after said cross-linking reaction.

11. The method for preparing radiation sensitive composition of claim 1, wherein said dissolving agents further comprises dissolving agents corresponding to said multi-hydroxyl polymers or said isocyanate derivatives.

12. Radiation sensitive composition prepared according to the method for preparing radiation sensitive composition of any of claim 1 to 11.

## Amended claims

### Amended claims in accordance with Rule 137(2) EPC.

**1.** A method for preparing a radiation sensitive composition comprising the steps:
- providing a solution A which comprises 92.196 wt% of a mixture of the condensation product of formaldehyde and m-cresol and the condensation product of formaldehyde and bisphenol A, 1.418 wt% of a radiation sensitive compound and 2.836 wt% of coloring agent(s) in a solvent; and
- adding 3.546 wt% of 2,4 (or 2,6)-toluene diisocyanate, and 0.004 wt% of dibutyltin dilaurate as cross-linking agent to the solution A,
wherein the cross-linking reaction is proceeded under 45 °C - 50 °C for 24 hours to obtain a modified radiation sensitive composition.

**2.** The method for preparing radiation sensitive composition of claim 1, wherein, in addition, acid generators are added.

**3.** The method for preparing radiation sensitive composition of claim 1, wherein the coloring agent(s) comprise crystal violet lactone.
